Europäisches Patentamt

European Patent Office

Office européen des brevets

(11) Publication number: **0 219 100**
**A2**

(12) **EUROPEAN PATENT APPLICATION**

(21) Application number: **86114222.2**

(22) Date of filing: **14.10.86**

(51) Int. Cl.⁴: **H 01 L 21/308**
**H 01 L 21/90**

(30) Priority: **16.10.85 JP 230356/85**

(43) Date of publication of application:
**22.04.87 Bulletin 87/17**

(84) Designated Contracting States:
**DE FR GB**

(71) Applicant: **Kabushiki Kaisha Toshiba**
**72, Horikawa-cho Saiwai-ku**
**Kawasaki-shi Kanagawa-ken 210(JP)**

(72) Inventor: **Hasegawa, Isahiro Patent Division, K.K.**
**Toshiba**
**1-1, Shibaura 1-chome Minato-ku**
**Tokyo 105(JP)**

(74) Representative: **Henkel, Feiler, Hänzel & Partner**
**Möhlstrasse 37**
**D-8000 München 80(DE)**

(54) Method of forming a fine pattern.

(57) The present invention relats to a method of forming a fine pattern. First, an object (13) to be etched, such as a metal film formed on a semiconductor substrate (11), is prepared. On the object (13), predetermined etching masks (16-1, 16-2) of organic material are formed, with which the object (13) is etched to obtain a predetermined pattern, such as wiring patterns (18-1, 18-2). In addition to the etching masks (16-1, 16-2), a dummy etching mask (17) of organic material is formed on the object (13), such that it does not affect the operation of the predetermined circuit. The sum of the areas of the etching masks (16-1, 16-2) and dummy etching mask (17) is determined such that it is greater than the value determined by the material of the object. If the object is fomed of Aℓ–Si, for example, the sum of the areas should be larger than 30%. Using both the etching masks (16-1, 16-2) and the dummy etching mask (17), the object (13) is etched by a reactive ion etching technique. Since the sum of the areas of the masks (16-1, 16-2, 17) is larger than the predetermined value, a protection film (20) is formed during the etching step, and this protection film (20) prevents the object (13) from being etched in the lateral direction. Therefore, the object (13) is prevented from having an undercut, or the like.

F I G. 3B

EP 0 219 100 A2

- 1 -

## Method of forming a fine pattern

The present invention relates to a method of forming a fine pattern, and more particularly, to an improved method of forming a fine pattern by a RIE process.

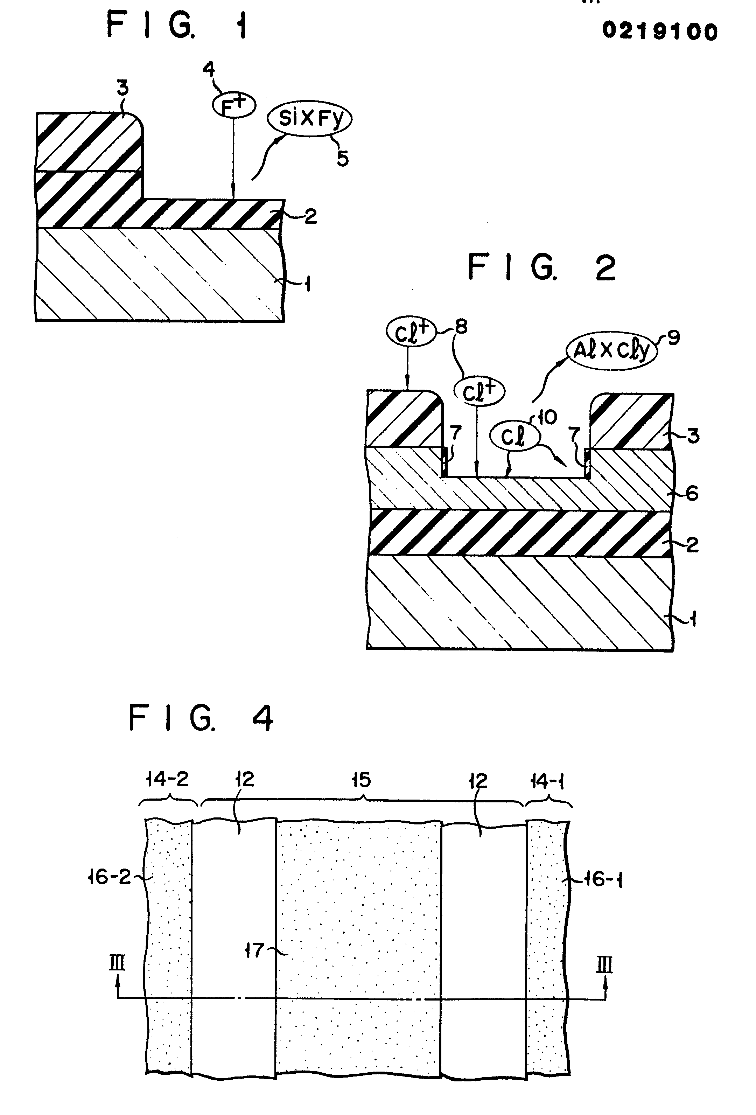

In the technical field of manufacturing semiconductor devices, reactive ion etching (RIE) is known as a technique suitable for etching a silicon oxide film, an aluminum film, or the like. A description will be given, with reference to Fig. 1, of how a silicon oxide film (SiO$_2$ film) is etched by the RIE technique. As is shown, firstly, SiO$_2$ film 2 is formed on semiconductor substrate 1, and then, patterned photoresist film 3 is formed on SiO$_2$ film 2. Fluorine ions (F$^+$) 4, produced in plasma and accelerated by an electric field, are made to strike against the surface of SiO$_2$ film 2, at right angles to that surface. Fluorine ions 4 react with SiO$_2$, producing volatile compound (Si$_x$F$_y$) 5. As a result, SiO$_2$ film 2 is etched off. If the film to be etched is an SiO$_2$ film, as in this case, etching is performed mainly by ions flowing in one particular direction, this type of etching being known as anisotropic etching.

Next, a description will be given, with reference to Fig. 2, of how a film containing Aℓ (for example, an Aℓ-Si film which contains 1% silicon by weight), is etched by the RIE technique. As is shown, firstly, $SiO_2$ film 2 is formed on semiconductor substrate 1, and then, $A\ell$-Si film 6 is formed on $SiO_2$ film 2. Patterned photoresist film 3 is formed on $A\ell$-Si film 6. In this case, chlorine ions 8, contained in plasma and accelerated by an electric field, are made to strike against the structure. As a result, $A\ell_x Cl_y$ 9 is produced, so that $A\ell$-Si film 6 is etched. Since $A\ell$-Si is a chemically active material, the etching is promoted by chlorine radicals 10, which are produced in the reaction chamber and which are electrically neutral. Unlike in the etching of the $SiO_2$ film, the etching shown in Fig. 2 is not performed in a particular direction. Even in the case shown in Fig. 2, however, organic materials, such as the material of photoresist film 3, resolve during the RIE and adhere to the side walls of the etched portion, thus forming coating (protection film or side wall passivation) 7. This coating prevents etching from being performed in the lateral direction of the structure, in spite of the presence of chlorine radicals 10. In this case, anisotropic etching is achieved.

In each of the above two cases, however, a comparatively small amount of organic material resolves if the etching area, i.e., the area which is to be etched off, is wide as compared to the entire area of the semiconductor wafer. For this reason, if the area to be etched is wide, a satisfactory coating film 7 cannot be obtained. As a result, an undercut may be formed in the wiring layers of semiconductor elements, cutting the wiring layers.

The object of the present invention is to provide a pattern-forming method enabling a fine pattern to be formed with high accuracy.

To achieve the above object, the fine pattern-forming method of the present invention comprises the steps of:

preparing an object to be etched;

forming at least one predetermined etching mask of organic material on the object, so as to etch the object to form a predetermined pattern, and forming at least one dummy etching mask of organic material on the object; and

etching the object by a reactive ion etching technique, using both the predetermined etching mask and the dummy etching mask.

As can be seen from the above, the dummy etching mask is formed in the method of the present invention. By use of the dummy etching mask, it is possible to provide a sufficient amount of organic material, even if the etching area necessary for obtaining a desirable pattern is wide and the amount of organic material for obtaining the desirable pattern is comparatively small. As a result, it is possible to form a satisfactory film of the organic material on the side walls of the etched portion of the object. It is, therefore, possible to anisotropically etch the object, in a reliable manner without causing an undercut in the object.

This invention can be more fully understood from the following detailed description when taken in conjunction with the accompanying drawings, in which:

Figs. 1 and 2 are views for illustrating the RIE process;

Figs. 3A-3C and Fig. 4 are views for illustrating the method of forming a fine pattern in a semiconductor device, according to one embodiment of the present invention;

Fig. 5 is a view for illustrating the second embodiment of the present invention;

Fig. 6 is a view for illustrating the third embodiment of the present invention;

Figs. 7 through 9 are views for illustrating the relationship between the amount of the photoresist and that of the undercut; and

Figs. 10 and 11 are views for comparing the wire cut rates between a semiconductor device manufactured according to one embodiment of the present invention and a semiconductor device manufactured according to a conventional method.

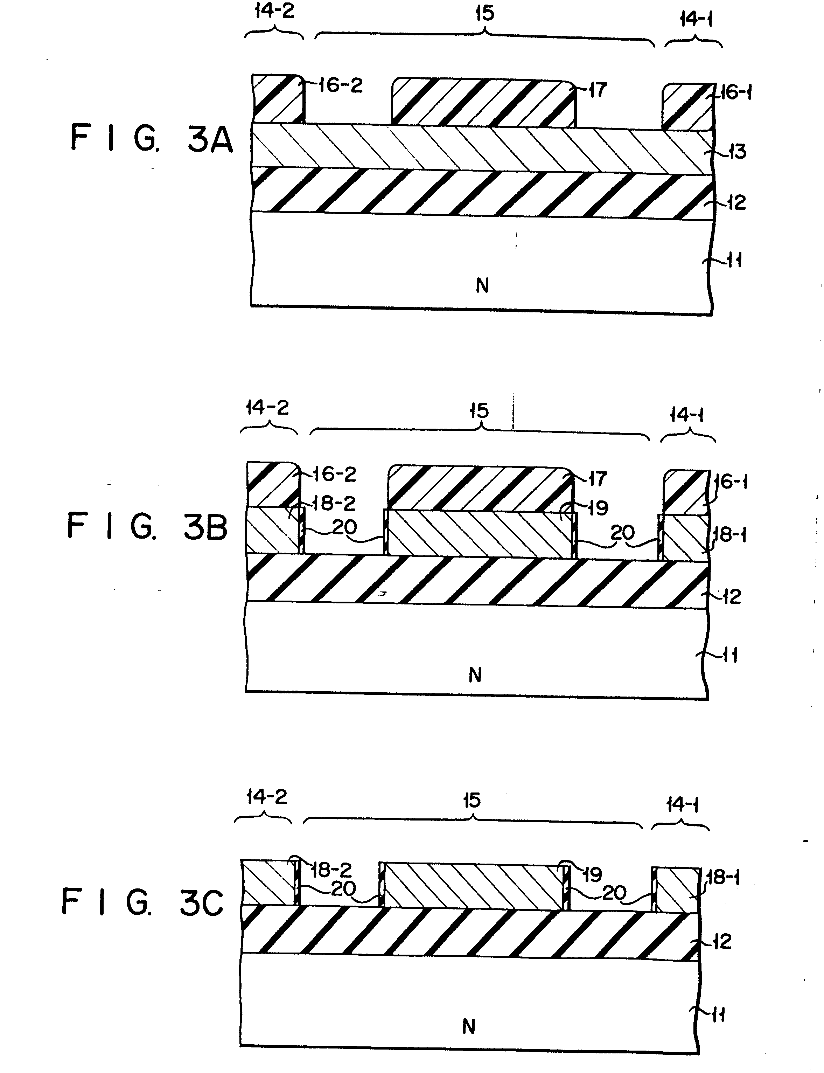

A description will now be given of one embodiment of the fine-pattern-forming method of the present invention, with reference to Figs. 3A-3C. In this embodiment, Aℓ-Si film 13 (Fig. 3A) is etched by the RIE technique, so as to form two wiring layers 18-1 and 18-2 (Fig. 3C) in a semiconductor integrated circuit.

As is shown in Fig. 3A, SiO$_2$ film 12 is formed on N-type silicon substrate 11, and Aℓ-Si film 13 is formed on SiO$_2$ film 12. In the following description, those regions of Aℓ-Si film 13 which remain and form two wiring layers 18-1 and 18-2 after the etching process, will be referred to as pattern regions 14, and the other regions of Aℓ-Si film 13 will be referred to as to-be-etched regions. To simplify the description, one of the pattern regions will be indicated by numeral 14-1 and the other will be indicated by numeral 14-2.

A photoresist film (not shown) is formed on the entire surface of Aℓ-Si film 13. To form wiring layers 18-1 and 18-2, the photoresist film is patterned such that photoresist masks 16-1 and 16-2 are provided in pattern regions 14-1 and 14-2, respectively. To form other wiring layers in addition to those indicated by 18-1 and 18-2, the photoresist film is made to remain also in that region where no photoresist is required; i.e., part of to-be-etched region 15 (the region will be referred to as a dummy region hereinafter). That portion of the photoresist film remaining in the dummy region constitutes photoresist pattern 17. Resist 17 is formed such that an Aℓ-Si pattern, which is formed through use of resist 17, does not adversely affect the operation of the resultant circuit. Resist 17 will be referred to as a "dummy resist." As it is undesirable that wiring layers 18-1 and 18-2 be electrically shorted to each other, dummy resist 17 is kept separate from resists 16-1 and 16-2, by a certain interval. By performing these processes, the structure shown in Fig. 3A is obtained.

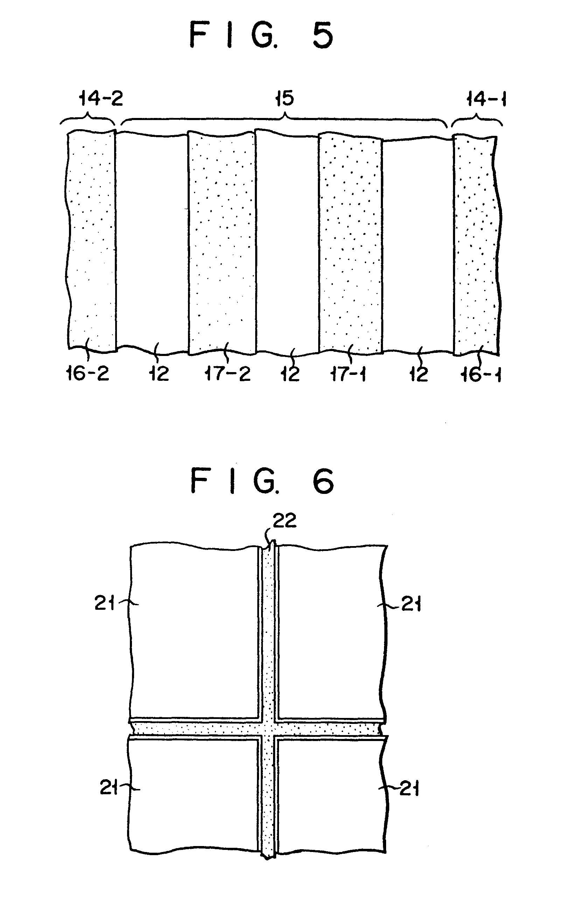

Using photoresists 16 and 17 as a mask, Al-Si film 13 is etched by a reactive ion etching apparatus which is of the plane parallel plate type. By this etching, wiring layers 18-1 and 18-2, made of Al-Si, are formed in pattern regions 14, and pattern 19, made of Al-Si, is formed in the dummy region of to-be-etched region 15, as is shown in Fig. 3B. Pattern 19 is electrically insulated from wiring layers 18-1 and 18-2 and does not participate in the circuit operation. Fig. 4 is a plan view of the structure shown in Fig. 3B. In Fig. 4, the photoresists are dotted, thereby distinguishing them from the other portions. Incidentally, the section taken along line III-III in Fig. 4 corresponds to the view shown in Fig. 3B.

During the RIE process, not only the organic materials contained in resists 16-1 and 16-2 in pattern regions 14 but also those contained in dummy resist 17, in to-be-etched region 15, resolve. Therefore, sufficiently thick protection films 20 can be formed on the side walls of wiring layers 18-1 and 18-2. Because of protection films 20, etching is prevented from being performed in the lateral direction of the structure, in spite of the presence of electrically neutral radicals such as chlorine radicals. Therefore, no undercut is formed in Al-Si film 13, thus permitting Al-Si film 13 to be etched anisotropically, as is shown in Fig. 3B.

After this etching, photoresists 16 and 17 are removed from the structure. The structure obtained after effecting the above processes, is shown in Fig. 3C. As can be seen from this Figure, the resultant structure has Al-Si pattern 19, which adversely affects neither the function of wiring layers 18-1 and 18-2 nor the circuit operation.

By performing the above-described processes with the structure shown in Fig. 3C, a predetermined semiconductor device (not shown) is obtained. Pattern 19 may be removed from the structure or it may be left as it is.

In the above embodiment, dummy photoresist 17 is intentionally formed in that region where no photoresist is required, in addition to photoresists 16 formed in pattern regions 14. The RIE process is performed with dummy resist 17 remaining on the structure. In the etching process, therefore, not only resists 16, located in pattern region 14 but also dummy resist 17, resolves. During the RIE process, therefore, sufficiently thick protection films 20 can be formed on the side walls of wiring layers 18, thus preventing an undercut from being formed in wiring layers 18. In this manner, wiring layers 18 are prevented from becoming too thin and narrow, and therefore being cut.

In the above embodiment, because wiring patterns 18 should not be electrically shorted to each other, pattern 19 is formed separately from wiring layers 18. However, pattern 19 may be formed such that it is in contact with one of wiring layers 18, as long as the circuit operates without any problem. In addition, dummy resist 17 need not be formed as one piece, such as that shown in Fig. 3A; it may be divided into dummy resist sections 17-1 and 17-2, as is shown in the plan view of Fig. 5.

In the above embodiment, a description was made of the case where dummy resist 17 is provided in to-be-etched region 15 between pattern regions 14, in addition to resist patterns 18 necessary for forming a predetermined circuit pattern. However, the present invention is not limited to this. The dummy photoresist may be provided at any region, as long as it does not become an obstacle to the manufacture of a semiconductor integrated circuit. For example, photoresist 22 may be formed on the dicing lines between semiconductor chips 21 on a semiconductor wafer, as is shown in Fig. 6. In this modification, photoresist 22 resolves during the RIE process, thereby permitting sufficiently thick protection films to be formed on the side walls of the wiring layers which are to be formed on semiconductor chip 21. Since the semiconductor chips are divided along the dicing lines, in the final stage of the manufacture, the dummy photoresists on the dicing lines do not adversely affect the operation of the semiconductor integrated circuit.

In the above embodiment, dummy resist 17 was described as being formed in to-be-etched region 15 between pattern regions 14. However, the present invention is not limited to this. The same effects can be obtained, for example, by the following method:

One half of the surface of a semiconductor wafer is intentionally covered with a dummy photoresist, and wiring layers are formed in the other half. Thereafter, the half in which the wiring layers are located is covered with a dummy photoresist, and other wiring layers are formed in the other half. With this method, satisfactory protection films 20 can be formed at the time of forming wiring layers, thus preventing an undercut from being formed.

In the above embodiment, Aℓ-Si film 13, formed on silicon substrate 11 with $SiO_2$ film 12 interposed, was etched by the RIE technique. However, the present invention is not limited to this. The invention can be applied to the case where the semiconductor substrate itself is etched by the RIE technique. In addition, the method of the present invention is applicable not only to the etching by which a predetermined circuit pattern is formed. For example, the method of the invention may be applied to the case where sheet coils are manufactured, by etching metal layers. In this case, a dummy photoresist is formed in that region or regions where it does not affect the manufacture of the coil, for example, at the corners of the metal layers, so as to obtain satisfactory protection films. Furthermore, if the method of the invention is applied to the formation of pits in a laser disc, a dummy photoresist is formed in that region where it does not affect the formation of the pits, before etching the substrate. In this case as well, pits can be formed without causing any undercut.

In the above embodiment, the organic material used for forming a protection film was a photoresist. However, the present invention is not limited to this. For example, organic conductive material may be used, in place of the photoresist.

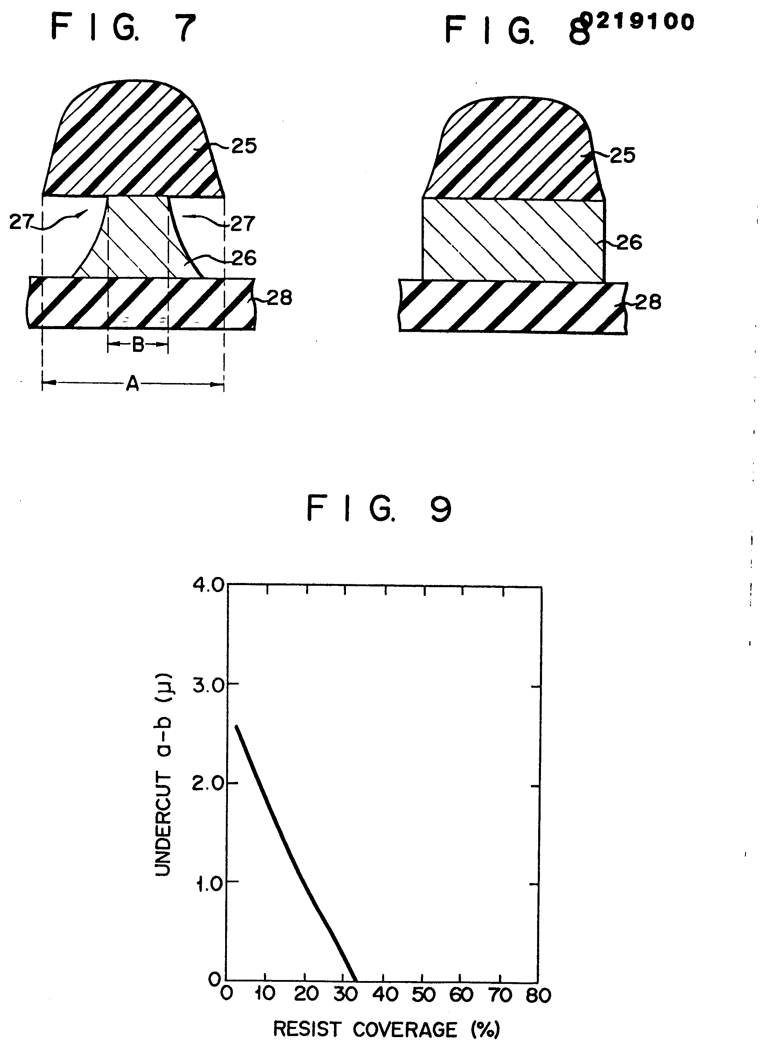

In the above embodiment and its modifications, the RIE process is effected after forming a dummy photoresist. However, even if the dummy photoresist is formed, it is not always possible to ensure reliable etching. The total size of the photoresist should be taken into consideration. The effect of etching was examined in relation to the size of the photoresist, based on the assumption that an Aℓ-Si wiring layer having a width of 2 μm and a thickness of 1 μm must be formed. A section of the wiring layers was examined, using photographs taken by a scanning electron microscope (SEM). Figs. 7 and 8 are schematic views of the SEM. Fig. 7 illustrates the case where about 20% of the area of the semiconductor substrate (or the semiconductor wafer) is covered with the photoresist, while Fig. 8 illustrates the case where about 50% of the area of the semiconductor surface is covered with the photoresist. As can be seen from these Figures, an undercut was formed in Aℓ-Si layer 26 in the 20% case, but none was formed in the 50% case.

The relationship between the coverage ratio of the photoresist and the amount of the undercut was further examined. In this examination, the amount of undercut was measured, using as a parameter the ratio of the area of the photoresist to the entire area of the semiconductor wafer (i.e., [area of the photoresist]/ [entire area of the semiconductor wafer] × 100). The ratio will be referred to as a "covering percentage". Specifically, as is shown in Fig. 7, the width of etching mask 25 was represented by A, and the smallest width of wiring layer 26 was represented by B. The remainder, obtained by subtracting the value of B from that of A, was defined as representing the amount of the undercut. In Fig. 9, the abscissa represents the covering percentage, and the ordinate represents the amount of undercut. As can be seen from Fig. 9, it was confirmed that the amount of undercut increases with a decrease in the covering percentage. It was also confirmed that, in the case of Aℓ-Si, hardly any undercut was formed if the covering percentage was 30%, and no undercut at all was formed if the covering percentage was more than 35%. In summary, if more than 30% of the area of the semiconductor wafer was covered with a photoresist which is used for forming a predetermined pattern (e.g., resists 18 in Fig. 3B) and with a dummy resist (e.g., resist 19 in Fig. 3B), etching could be performed without causing any undercut. Likewise, it was confirmed that hardly any undercut was formed if the covering percentage exceeds 10% in the case of polysilicon, 30% in the case of aluminum, 40% in the case of Aℓ-Cu or Aℓ-Si-Cu, 15% in the case of a high-melting point metal (Ti, Mo, etc.), 5% in the case of a single crystalline silicon, 12% in the case of a polysilicon doped with impurities, 10% in the case of a silicide (i.e., an alloy of silicon and high-melting point metal), and 15% in the case of a double-layer structure formed by a layer of either a high-melting point metal or silicide and by a film of polysilicon.

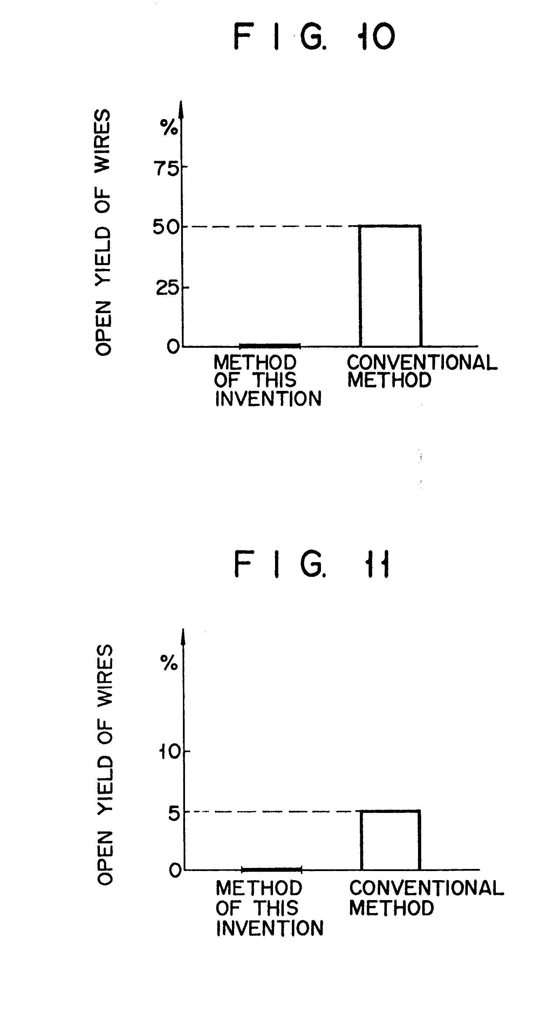

Next, experiments were conducted to confirm the effects of the present invention. A wiring layer having a width of 2 µm and a thickness of 1 µm was formed according to the above embodiment of the present invention and according to a conventional method. The cut rate of the wiring layers was measured with respect to the two wiring layers. In the conventional method, the covering percentage of the resist used for forming a predetermined pattern was 25%, while in the embodiment of the present invention, the dummy resist (the covering percentage of which was 15%) was formed, in addition to the resist (the covering percentage of which was 25%) similar to that formed in the conventional resist, so that the total covering percentage of the photoresist was 40%. As is shown in Fig. 10, the electrical open yield of the wiring layer formed in the conventional method was 50%, but the electrical open yield of the wiring layer formed according to the embodiment of the present invention was 0%.

Furthermore, wiring layers with no electrical cut were prepared. The electrical open yield of these wiring layers were tested after continuously supplying electrical bias to them for 1000 hours. The results are shown in Fig. 11. As shown, the electrical open yield of the wiring layers formed in the conventional method was 5%, but the cut rate of the wiring layers formed in the present invention was 0%. It was, therefore, confirmed that the pattern-forming method of the present invention was much more advantageous than the conventional method.

- 1 -                                    0219100

Claims:

1.  A pattern-forming method which comprises the steps of:

preparing an object to be etched;

forming at least one predetermined etching mask of organic material, so as to etch the object to form a predetermined pattern; and

etching the object by a reactive ion etching technique, using the predetermined etching mask, thereby etching the object,

characterized in that

the etching mask-forming step includes the step of forming at least one dummy etching mask (17) of organic material, in addition to the predetermined etching mask (16), and

the etching step is the step of etching the object (13) by the reactive ion etching technique, using both the predetermined etching mask (16) and the dummy etching mask (17), thereby forming both the predetermined pattern (18) and a pattern (19) corresponding to the dummy etching mask (17).

2.  A pattern-forming method according to claim 1, characterized in that the pattern-forming method is a method for manufacturing a semiconductor integrated circuit,

the predetermined etching mask (16) is an etching mask by which the object (13) is etched to obtain the predetermined circuit pattern (18), and

the dummy etching mask (17) serves to etch the object into a pattern (19) corresponding to the dummy etching mask (17), this pattern not having any electrical influence on the operation of the circuit pattern (18).

3.  A pattern-forming method according to claim 1, characterized in that the object (13) is formed of at least one of the following: aluminum; aluminum alloy; a high-melting point metal; alloy of a high-melting point material; a single crystalline silicon; polycrystal silicon; polycrystal silicon doped with impurities; a silicide; a double-layer structure formed by a layer of either a high-melting point metal or a silicon and by a layer of polysilicon.

4. A pattern-forming method according to claim 1, characterized in that the organic material is at least one of a photoresist and an organic conductive material.

5. A pattern-forming method according to claim 1, characterized in that the ratio of the sum of the areas of the predetermined etching mask (16) and dummy etching mask (17) to the area of the object (13), is larger than a value determined by the type of the obejct (13).

6. A pattern-forming method according to claim 1, characterized in that a percentile ratio of the sum of the areas of the predetermined etching mask (16) and dummy etching mask (17) to the area of the object (13), is larger than 30% if the object (13) is formed of $A\ell$-Si, larger than 25% if the object (13) is formed of $A\ell$, larger than 35% if the object (13) is formed of $A\ell$-Cu, larger than 35% if the object is formed of $A\ell$-Si-Cu, larger than 7% if the object (13) is formed of polysilicon, larger than 12% if the object is formed of a high-melting point metal, larger than 5% if the object is formed of a single crystalline silicon, larger than 12% if the object is formed of a silicon doped with impurities, larger than 10% if the object is formed of a silicide, larger than 15 if the object is a double-layer structure formed by a layer of either a high-melting point metal or a silicide and by a layer of polysilicon.

7. A pattern-forming method according to claim 1, characterized in that the object (13) is a metal film used for forming the wiring pattern (18) of the semiconductor integrated circuit,

the predetermined mask pattern (16) is a mask pattern used for forming the wiring pattern (18) of the semiconductor integrated circuit, and

the dummy etching mask (17) is used for forming a pattern of the metal film (13), which pattern corresponds to the dummy etching mask (17) without having any electrical influence on the operation of the predetermined circuit pattern (18).

8. A pattern-forming method according to claim 7, characterized in that the dummy etching mask (17) is formed on dicing lines of a semiconductor wafer.

9. A pattern-forming method according to claim 1, characterized by further comprising the steps of:

removing the predetermined etching mask (16) and the dummy etching mask (17); and

removing the pattern (19) formed on the object (13) and corresponding to the dummy etching mask (17).

10. A pattern-forming method according to claim 1, characterized in that the sum of the areas of the predetermined mask pattern (16) and dummy mask pattern (17) is larger than a value that enables predetermined protection films (20) to be formed on side walls of the predetermined pattern (18), the predetermined protection films (20) preventing the object (13) from being etched in the lateral direction during the etching step, thus preventing an undercut from being formed in the predetermined pattern (18).

# FIG. 1

3
4 F⁺
SiₓFy 5
2
1

# FIG. 2

Cl⁺ 8
Cl⁺
AlₓClᵧ 9
7
Cl 10
7
3
6
2
1

# FIG. 4

14-2   12      15      12   14-1
16-2
17
16-1
III                              III

FIG. 3A

14-2    15    14-1

16-2    17    16-1

13

12

11

N

FIG. 3B

14-2    15    14-1

16-2    17    16-1
18-2    19    18-1
20    20

12

11

N

FIG. 3C

14-2    15    14-1

18-2    19    18-1
20    20

12

11

N

0219100

# FIG. 5

14-2   15   14-1

16-2   12   17-2   12   17-1   12   16-1

# FIG. 6

22

21   21

21   21

# F I G.  7

# F I G.  8

# F I G.  9

0219100

# F I G. 10

OPEN YIELD OF WIRES

%
75
50
25
0

METHOD OF THIS INVENTION    CONVENTIONAL METHOD

# F I G. 11

OPEN YIELD OF WIRES

%
10
5
0

METHOD OF THIS INVENTION    CONVENTIONAL METHOD